# EUROPEAN PATENT SPECIFICATION

(11) **EP 0 394 923 B1**
(45) Date of publication and mention of the grant of the patent: **03.07.1996**
(21) Application number: 90107662.0
(22) Date of filing: 23.04.1990
(51) Int. Cl.: G03F 7/075

(54) **Photosensitive lithographic printing plate requiring no wetting water**
Lichtempfindliche Flachdruckplatte, die kein Befeuchtungswasser benötigt
Plaque d'impression lithographique photosensible ne nécessitant pas d'eau de mouillage

(30) Priority: 24.04.1989 JP 104286/89
(43) Date of publication of application: 31.10.1990
(73) Proprietor: KONICA CORPORATION, Tokyo 160 (JP)
(72) Inventor: Tomiyasu, Hiroshi, 2-25 Minamino 3-chome, Tama-shi, Tokyo (JP); Kasakura, Akeo, Yokohama-shi, Kanagawa-ken (JP); Suzuki, Norihito, Hachioji-shi, Tokyo (JP); Nakajima, Akihisa, Hachioji-shi, Tokyo (JP)
(74) Representative: TER MEER - MÜLLER - STEINMEISTER & PARTNER

(56) References cited:
- EP-A- 0 152 819
- EP-A- 0 226 201
- EP-A- 0 307 776
- EP-A- 0 316 705
- EP-A- 0 349 157

## Description

### Description for the following Contracting States: DE, GB

### Photosensitive lithographic printing plate requiring no wetting water

This invention relates to a photosensitive lithographic printing plate, more particularly, a photosensitive lithographic printing plate which comprises a support and a photosensitive layer and a silicone rubber layer applied on the surface of the support in this order and does not require wetting water in printing, provided that the silicone rubber layer does not contain a copolymer having a silicone macromer and a fluorine-containing monomer in its molecular structure.

In the lithography, printing is effected based on delicate balance of ink and water created by lipophilicity of the image portion and hydrophilicity of the non-image portion, wherein considerable skill is required.

In the printing system in which wetting water is required, printing plates are prepared by exposing a plate which comprises a hydrophilic support and a lipophilic photosensitive layer provided on the former to light through an image film and developing the plate so as to form the lipophilic image portion and the hydrophilic non-image portion. In printing, the non-image portion is wetted and printing ink is applied on the image portion. The ink adheres to the image portion only and not to the wetted non-image portion. In this printing system, however, the control of delicate balancing of the wetting water and the printing ink is difficult and often emulsification of ink or immigration of ink to the non-image portion occurs causing insufficiency in ink density or staining of the non-image portion, and wastes paper.

There is also a problem that the wetting water is transferred to printing paper, which causes dimensional change of paper inviting difficulty especially in multicolor printing.

Therefore, development of lithographic printing plate which does not require the wetting water (hereinafter, we call it "waterless lithographic plate" in places) has been attempted. Japanese Patent Publication Nos. 44-23042 and 46-16044 disclose waterless lithographic plates which comprise a support, a photosensitive layer and a silicone rubber layer provided on the photosensitive layer, and processes for preparing a printing plate wherein the silicone rubber layer is removed when the plate is developed and the photosensitive layer is dissolved by a developer. Japanese Patent Publication Nos. 56-26923 and 54-23150 disclose similar lithographic plates which comprise a support, a photosensitive layer and a silicone rubber layer and processes for preparing a lithographic printing plate, wherein the photosensitive layer is not dissolved but photochemical adhesion or photochemical separation of the photosensitive layer and the silicone rubber layer is caused and thus the silicone rubber layer is selectively swelled and removed.

Further, Japanese Patent Publication No. 61-54219, Japanese Laid-Open Patent Publication Nos. 60-229031 and 62-194255 disclose waterless lithographic printing plates which comprise a support, a primer layer, a photosensitive layer and a silicone rubber layer.

In the processes disclosed in said Japanese Patent Publications Nos. 44-23042 and 46-16044, there is a problem that the image portion is rather deeply cleared in developing and, therefore, the printing ink must be thickly applied in order to sufficiently cover the image portion, and the adhesion between the photosensitive layer and the silicone rubber layer or the support is not entirely satisfactory. Also in the processes disclosed in said Japanese Patent Publication Nos. 54-26923 and 56-23150, the designing of the silicone rubber layer is difficult because delicate adhesion of the silicone rubber layer and the photosensitive layer is relied upon, and, therefore, the obtained printing plate is not satisfactory in the scratch resistance and reproducibility of the image, although the above-described difficulty in the ink application can be obviated.

Further in the process disclosed in said Japanese Laid-Open Patent Publication No. 60-229031, there is a defect that the adhesion of the photosensitive layer and the silicone rubber layer or the adhesion of the photosensitive layer and the primer layer, if the latter is employed, is not sufficient, although the above-described defects are overcome. In the processes of Japanese Patent Publication No. 61-54219 and Japanese Laid-Open Patent Publication No. 62-194255, the primer layer is heat-crosslinkable and is thermally cured after it has been applied on the surface of a support and, therefore, the process is inferior in productivity and economically disadvantageous.

The object of the present invention is to provide a photosensitive lithographic printing plate which does not require wetting water. Particularly, it is to provide a photosensitive lithographic printing plate excellent in the adhesion of the photosensitive layer and the support or the primer layer, which does not require wetting water.

In order to solve the above problems, we carried out an intensive study and have found that the above-mentioned object can be achieved by a photosensitive lithographic printing plate which comprises a support and at least a photosensitive layer and a silicone rubber layer provided on the support in this order, provided that the silicone rubber layer does not contain a copolymer having a silicone macromer and a fluorine-containing monomer in its molecular structure, said photosensitive layer containing (1) a diazo resin and (2) a polymer of an ester or amide of (meth)acrylic acid having hydroxyl groups or a photosensitive lithographic printing plate which comprises a support and at least a primer layer, a photosensitive layer and a silicone rubber layer provided on the support in this order, provided that the silicone rubber layer does not contain a copolymer having a silicone macromer and a fluorine-containing monomer in its molecular structure, said photosensitive layer containing at least (1) a diazo resin and (2) a polymer of an ester or amide of (meth)acrylic acid having hydroxyl groups. These photosensitive lithographic printing plates do not require wetting water.

Now the invention will be specifically described in detail.

The photosensitive layer used in the present invention contains a diazo resin and a polymer of an ester or amide of (meth)acrylic acid having hydroxyl groups (hereinafter referred to as "hydroxyl-containing polymer") as an essential component.

As the above-mentioned diazo resin, a diazo resin obtained by condensation of a diazo compound and an active carbonyl compound (such as formaldehyde, acetoaldehyde or benzaldehyde) in an acidic solvent such as sulfuric acid, phosphoric acid, hydrochloric acid as described in page 33 of Vol. 17 (1973) of "Photographic Science and Engineering", U.S. Patent Nos. 2,063,631; 2,679,498; 3,050,502; Japanese Laid-Open Patent Publication No. 59-78340; a diazo resin obtained by condensation of a diazo compound and a diphenylether derivative as described in Japanese Patent Publication No. 49-4001 can be used.

The counter anions of the diazo resin used in the present invention include anions which form stable salts with said diazo resin and that makes said resin soluble in organic solvents. These include organic carboxylic acids such as decanoic acid, benzoic acid; organic phosphoric acid such as phenylphosphoric acid, sulfonic acid. Typical examples are, aliphatic and aromatic sulfonic acids such as methanesulfonic acid, chloroethanesulfonic acid, dodecanesulfonic acid, benzenesulfonic acid, toluenesulfonic acid, benzenesulfonic acid, mesitylenesulfonic acid, anthraquinonesulfonic acid, 2-hydroxy-4-methoxybenzophenone-5-sulfonic acid, hydroquinone sulfonic acid, 4-acetylbenzenesulfonic acid, dimethyl-5-sulfo-isophthalates; hydroxyl-containing aromatic compounds such as 2,2',4,4'-tetrahydroxybenzophenone; 1,2,3-trihydroxybenzophenone; 2,2',4-trihydroxybenzophenone; perhalogenated Lewis acids such as hexafluorophosphoric acid, tetrafluoroboric acid; perhalogenic acids such as HClO₄, HIO₄, although they are not limited thereto. The diazo resins having a weight average molecular weight of 200-10000, preferably 500-5000 with styrene as reference, measured by the gel permeation chromatography (GPC) of a coupling product with β-naphthol.

In the present invention, the photosensitive layer, usually contains 1-90 wt.%, preferably 3-60 wt.% of the above-described diazo resin.

In the present invention, polymers of an ester or amide of (meth)acrylic acid containing alcoholic hydroxyl groups are preferred as a hydroxyl-containing polymers. Examples of the usable ester or amide of a (meth)acrylic acid containing alcoholic hydroxyl groups are 2-hydroxyethyl acrylate, 2-hydroxyethyl methacrylate, N-(4-hydroxyethylphenyl) methacrylamide, hydroxymethyldiacetone (meth)acrylamide.

Examples of the monomers copolymerizable with the above-mentioned hydroxyl-containing monomer are:
(1) aromatic hydroxyl-containing monomers such as N-(4-hydroxyphenyl)acrylaride, N-(4-hydroxyphenyl)methacrylamide, N-(4-hydroxyphenyl)methacrylamide; o-, m- or p-hydroxystyrene; o-, m- or p-hydroxyphenyl acrylate or methacrylate;
(2) α-β unsaturated carboxylic acids such as acrylic acid, methacrylic acid, maleic anhydride;
(3) (substituted) alkyl acrylates such as methyl acrylate ,ethyl acrylate, propyl acrylate, butyl acrylate, amyl acrylate, hexyl acrylate, octyl acrylate, 2-chloroethyl acrylate 2-hydroxyethyl acrylate, glycidyl acrylate, N-dimethylaminoethyl acrylate;
(4) (substituted) alkyl methacrylates such as methyl methacrylate, ethyl methacrylate, propyl methacrylate, butyl methacrylate, amyl methacrylate, cyclohexyl methacrylate, 2-hydroxyethyl methacrylate, 4-hydroxybutyl methacrylate, glycidyl methacrylate, N-dimethylaminoethyl methacrylate;
(5) acrylamides or methacrylamides such as acrylamide methacrylamide, N-methylolacrylamide, N-ethylacrylamide, N-hexylmethacrylamide, N-cyclohexylacrylamide, N-hydrohexyethylacrylamide, N-phenylacrylamide, N-nitrophenylacrylamide, N-ethyl-N-phenylacrylamide;
(6) vinyl ethers such as ethylvinylether, 2-chloroethyl vinylether, hydroxyethylvinylether, propylvinylether, butylvinylether, octylvinylether, phenylvinylether;
(7) vinyl esters such as vinyl acetate, vinyl chloroacetate, vinyl butyrate, vinyl benzoate;
(8) styrenes such as styrene, α-methylstyrene, chlorostyrene;
(9) vinyl ketones such as methylvinyl ketone, ethylvinyl ketone, propylvinyl ketone, phenylvinyl ketone;
(10) olefins such as ethylene, propylene, isobutylene, butadiene, isobutylene;
(11) N-vinylpyrrolidone, N-vinylcarbazol, 4-vinylpyridine, acrylonitrile, methacrylonitrile.

The hydroxyl group content of the above-described monomer containing a hydroxyl group is not specifically limited, although it is preferably 5-100 wt.% and more preferably 20-100 wt.%.

The weight average molecular weight of the hydroxyl-containing polymer in accordance with the present invention measured by the GPC method (in comparison with styrene reference) should preferably be 5,000-1,000,000. If the molecular weight is less than 5,000, the photosensitive layer after exposure to light may still be attacked by the solvent or the developing solution and, if the molecular weight is more than 1,000,000, the usable solvent is limited.

The content of the above-described hydroxyl-containing polymer in the photosensitive layer is usually 10-99 wt.% and preferably 40-97 wt.%.

The weight content ratio of the diazo resin and the hydroxyl-containing polymer should preferably be 1/99 - 90/10.

If the diazo resin content ratio is less than 1/99, the light-exposed resin is not sufficiently crosslinked and thus may be attacked by the solvent applied or a developing solution. On the other hand, when the diazo resin content ratio is more than 90/10, the polymer content is small, i.e., the hydroxyl content is small and thus the adhesion to the silicone rubber layer becomes unsatisfactory.

The photosensitive layer in accordance with the present invention may contain other photosensitive substances which contain addition-polymerizable vinyl groups and become insoluble upon exposure to light.

The compounds having addition-polymerizable vinyl groups are compounds which have two or more polymerizable terminal ethylenic groups and have a boiling point of not lower than 100°C under the normal pressure, such as unsaturated carboxylic acid, esters of an unsaturated carboxylic acid and an aliphatic polyhydroxyl compound, esters of an unsaturated carboxylic acid and an aromatic polyhydroxylic compound, esters of an unsaturated carboxylic acid and a polybasic carboxylic acid or the above-mentioned aliphatic polyhydroxylic compound or the aromatic polyhydroxyl compounds. Specific examples are described in Japanese Laid-Open Publication No. 59-71048.

The photosensitive layer in accordance with the present invention may contain a dye, a pigment, a visualizer-upon-exposure, an applicability-improver. in addition to the above-described ingredients in order to improve image-visibility after exposure, image-visibility after development and applicability.

Examples of the usable dyes are triphenylmethane, diphenylmethane, oxazine, xanthene, iminonaphthoquinone, azomethine or anthraquinone dyes such as victoria pure blue BOH, oil blue #603, oil pink #312, patent pure blue, crystal violet, leucocrystal violet, brilliant green, ethyl violet, methyl green, erythrosine B, basic fuchsin, malachite green, leucomalachite green, m-cresol purple, cresol red, xylenol blue, rhodamine B, auramine, 4-p-diethylaminophenyliminonaphthoquinone, cyano-p-diethylaminophenylacetoanilide.

The above-mentioned resins are contained in the photosensitive layer usually in an amount of about 0.01 - about 10 wt.%, preferably about 0.05 - about 8 wt.%.

Examples of the applicability-improver are an alkylether such as ethyl cellulose, methyl cellulose, etc., fluorine-containing surfactants, nonionic surfactants such as Pluronic L-64 (marketed by Asahi Denka K.K.), FC-430 (marketed by Sumitomo 3M K.K.).

Examples of the visualizer-upon-exposure are oxadiazole compounds as described in Japanese Laid-Open Patent Publication No. 54-74728, triazine compounds as described in Japanese Laid-Open Patent Publication No. 53-36223.

In the present invention, the thickness of the photosensitive layer is preferably 0.1 mg/dm² - 30 mg/dm² and more preferably 0.5 mg/dm² - 18 mg/dm².

In the present invention, a primer layer can be provided between the above-described photosensitive layer and the support.

Known various primer layers can be employed. The primer layer which is formed by thermally curing an epoxy resin, polyurethane resin. with the aid of a suitable hardener as described in Japanese Laid-Open Patent Publication No. 61-54219; the primer layer which is formed by photochemically curing a dimeric photo-curable resin as described in Japanese Laid-Open Patent Publication No. 60-229031 can be employed. The diazo resins used for the photosensitive layer can be used for the primer layer usually in an amount of 1-90 wt.%, preferably 3-60 wt.%. The same hydroxyl-containing polymer as used for the photosensitive layer, polyvinyl alcohol derivatives, epoxy resins, novolak resins, gelatin, cellulose can be used for the primer layer. These hydroxyl-containing polymers are contained in an amount of 10-99 wt.%, preferably 40-97 wt.%.

In the present invention, the primer layer may contain fillers such as titanium dioxide, halationpreventers, coloring agents such as dyes and pigments, applicability-improvers, plasticizers, stabilizers, oleophilizers in an amount of not more than 10 wt.% in addition to the above-described essential components.

The same dyes and applicability-improvers as used for the photosensitive layer can be used for the primer layer.

Examples of the plasticizers, which provide flexibility, abrasion resistance, are butyl phthalate, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, oligomers of acrylic or methacrylic acid.

In order to improve affinity of the image portion to printing ink, various additives having hydrophobic groups including modified novolak resins such as p-octylphenol-formalin novolak resin, p-t-butylphenol-formalin novolak resin, p-t-butylphenol-benzaldehyde resin, and o-naphthoquinonediazide sulfonic acid esters (the esterification rate of the OH groups is 20-70 mol%) of these modified novolak resins can be added.

The primer layer is formed by dissolving the above-described photo-curable diazo resin or a composition containing the same and a hydroxyl-containing polymer in a suitable solvent together with other additives as desired, applying the solution on the support, drying, exposing to light so as to completely decompose the diazo resin and hardening.

The thickness of the primer layer is preferably 1 mg/dm² - 200 mg/dm² and more preferably 3 mg/dm² - 100 mg/dm².

In the present invention, a silicone rubber layer is provided on the above-described photosensitive layer. Linear or somewhat crosslinked organopolysiloxanes are preferably used as a silicone rubber. Said organopolysiloxanes have a molecular weight of several thousand to several hundred thousand and are liquid and wax-like or jelly-like with a suitable consistency if they are crosslinked to some extent. Crosslinking of said organosiloxanes is either of condensation type or of addition type.

Condensation type crosslinking is effected by a condensation reaction, wherein water, alcohol, organic acid, etc. are liberated. A mixture of a linear organopolysiloxane, which has hydroxyl groups at both ends or in a part of the main chain, and a silicone crosslinking agent and the reaction product of the two are especially useful. In either case, a condensation catalyst is preferably added.

The main chain of said organopolysiloxanes comprises the repeating unit 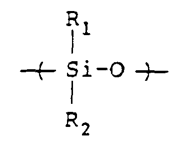 wherein R₁ and R₂ are respectively an alkyl, aryl or alkenyl group which may have substituents such as cyano, halogen, hydroxyl or combination thereof. Methyl, phenyl, vinyl and trifluoropropyl are preferred and methyl is most preferred.

Said silicone crosslinking agents are deacetation type, deoximation type, dealcoholization type, deamination type, or dehydration type condensation silicone crosslinking agents, which contain functional groups represented by 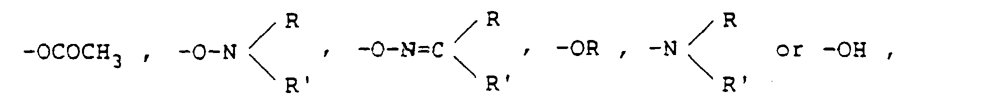 wherein R and R' stand for alkyls. Specific examples thereof are tetraacetoxysilane, methyltriacetoxysilane, ethyltriacetoxysilane, phenyltriacetoxysilane, dimethylacetoxysilane, diethylacetoxysilane, vinyltriacetoxysilane, methyltrimethoxysilane, dimethyldimethoxysilane, vinyltrimethoxysilane, methyl-tris-(acetonoxime)silane, methyl-tri(N-methyl-N-acetylamino)silane, vinyl-tri(methylethylketoxime)silane, methyl-tri(methylethylketoxime)silane, oligomers thereof.

The crosslinking agent is preferably used in an amount of 0.5-30 parts by weight per 100 parts by weight of organopolysiloxane.

Examples of the above-mentioned condensation catalysts are organic tin carboxylate, titanate esters, naphthenic acid.

The term "addition type condensation catalyst" means those of which hydrogen adds to unsaturated groups such as the vinyl(-CH=CH₂) group in the organopolysiloxane.

Specific examples are a mixture of a vinyl-containing organopolysiloxane, hydrogenated organopolysiloxane and a platinum catalyst (chloroplatinic acid, for instance).

Said organopolysiloxanes have the same repeating units as described above with respect to that of the condensation type in the main chain.

Either of condensation type silicone rubber and addition type silicone rubber or both can be used as the silicone rubber layer in the present invention.

Organopolysiloxanes which have both hydroxyl groups and unsaturated groups and are of both condensation type and addition type can also be used.

Of the commercially available silicone rubbers usable in the present invention, preferred are condensation type silicoqe rubbers such as KS-705F; KE-41, 42 and 44 supplied by Shin'etsu Kagaku K.K.; YE5505, YF3057, supplied by Toshiba Silicone K.K.; SH-781, PRX-305, SH-237 supplied by Toray Silicone K.K. and addition type silicone rubbers KS-837, KE-103, KE-106, KE-1300 supplied by Toshiba Silicone; TSE-3032, RTU-B supplied by Toshiba Silicone K.K.; SH-9555 supplied by Toray Silicone K.K..

Inorganic fillers such as silica, titanium oxide, aluminum oxide can be used in order to improve the strength of silicone rubber. Silica is preferred. Fillers having average particle diameter of not larger than 500 nm are preferred from the viewpoint of dispersibility and dispersion stability.

The thickness of the silicone rubber layer in the present invention should preferably be as small as possible from the viewpoints of image quality and developability. From the viewpoint of printing durability and resistance to staining, however, some extent of thickness is required. Therefore, 3 mg/dm² - 50 mg/dm² is preferable and 5 mg/dm² - 30 mg/dm² is more preferable.

An adhesive layer of an epoxy resin, for instance, can be provided between the photosensitive layer and the silicone rubber layer. Various kinds of reactive crosslinking agent, silane couplers can be used for the adhesive layer. The thickness of the adhesive layer should preferably be 0.1 mg/dm² - 5 mg/dm².

In the waterless lithographic printing plate of the present invention, a protective layer may be provided on the surface of the silicone rubber layer. Such a protective layer can be provided by laminating a polypropylene film as disclosed in Japanese Laid-Open Patent Publication No. 61-614 or applying a high polymer as disclosed in Japanese Laid-Open Patent Publication No. 61-27545.

Any support plates which can be set on ordinary lithographic printing apparatuses and have satisfactory flexural rigidity to bear the load in printing can be used in the present invention, and are not specifically limited in material and structure. Paper such as coated paper, metal plates such as aluminum plate, sheets of plastics such as polyethylene terephthalate are used.

However, aluminum plate or composite material including aluminum foil is preferable and aluminum plate is most preferred from the viewpoint of printing durability.

In the present invention, the surface of aluminum plates and aluminum foils are preferably roughened, anodized and further treated with a silicate salt. The silicate treatment is carried out by soaking aluminum plates in a 0.1-10% sodium silicate aqueous solution for 1 sec. - 2 min. at 30-95°C, preferably for 10 sec. - 2 min. at 40-95°C.

The thus prepared photosensitive lithographic printing plate is imagewise exposed and developed with a developer so as to remove the photosensitive layer together with the silicone rubber layer. Thus the support and the primer layer appear as the image portion and thus a waterless lithographic printing plate is obtained.

The image portion will preferably be dyed during or after developing with a cathionic dye such as crystal violet, victorian blue BOH.

Any light sources which emit ultraviolet rays and visible rays having a wavelength of not less than 180 nm can be used for exposure although a carbon arc light, a mercury lamp, a xenon lamp, a metal halide lamp and strobo light are suitable.

The developer for developing the photosensitive layer is an aqueous solution containing a polar solvent, an alkaline compound such as an amine, a surfactant, and further an aliphatic hydrocarbon (hexane, heptane, "Isopar E.E.G." supplied by Esso Chemical Company, gasoline, kerosene), an aromatic hydrocarbon (toluene, xylene, etc.) or a halogenated hydrocarbon (triclene) as desired.

### Polar Solvents

Alcohols such as methanol, ethanol, water, etc.

Ethers such as methyl cellosolve, ethyl cellosolve, butyl cellosolve, methyl carbitol, ethyl carbitol, butyl carbitol, dioxane.

Ketones such as acetone, methylethylketone, etc.

Esters such as ethyl acetate, methyl cellosolve acetate, cellosolve acetate, carbitol acetate.

Developing can be effected by any known procedure such as rubbing the plate with a developing pad containing a developer as described above, pouring the developer on the surface of the printing plate and, thereafter, rubbing with a developing brush.

### Specific Description of the Invention

Now the invention will be illustrated in detail by way of working examples.

### [Synthesis of Diazo Resin No. 1]

Under the ice-cooled condition, 14.5 g of p-diazophenylamine sulfate was dissolved in 40.9 g of concentrated sulfuric acid. To this solution, 1.0 g of paraformaldehyde was slowly added so that the temperature would not exceed 10°C. The reaction mixture was further stirred under the ice-cooled condition for 2 hours. Thereafter, the reaction mixture was dropped into 500 ml of ethanol. The formed precipitate was collected by filtration, and washed with ethanol. The thus obtained precipitate was dissolved in 100 ml of pure water, and a cold thick solution containing 6.8 g of zinc chloride was added. The formed precipitate was collected by filtration, washed with ethanol and dissolved in 150 ml of pure water. To this solution, a cold concentrated solution containing 8 g of hexafluorophosphoric acid ammonium was added. The formed precipitate was collected by filtration, washed and dried at 30°C for 24 hours. Thus Diazo Resin No. 1 was obtained.

The weight average molecular weight Mw of the Diazo Resin No. 1 measured with respect to a coupling product with β-naphthol by the GPC process was 1500 with styrene as reference. The number average molecular weight was 500.

### [Synthesis of Polymer No. 1]

To 700 g of the rectified dioxane, 150 g of 2-hydroxyethyl methacrylate, 60 g of acrylonitrile, 79.5 g of methyl methacrylate and 10.5 g of methacrylic acid (37:35:24:4 in the molar ratio) were added (the total monomer concentration was 4.6 moles/ℓ), and to the resulting solution, 15 g (2 mol.%) of benzoyl peroxide was slowly added to allow polymerization under refluxing in a nitrogen atmosphere for 8 hours. After the reaction was finished, 0.5 g of hydroquinone was added to the reaction mixture and the solvent was distilled away under reduced pressure. When the mixture became viscous, the polymer mixture was poured onto a stainless steel plate and dried in vacuo. Thus 270 g of resin (Polymer No. 1) in the form of a plate was obtained. The measured GPC value of the polymer was as follows.
Mw: 4.80 × 10⁴, dispersion ratio: 2.2

### [Synthesis of Polymer No. 2]

Polymer No. 2 was obtained by repeating the procedures of Synthesis of Polymer No. 1 using hydroxymethyldiacetonemethacrylamide.

The Mw value of Polymer No. 2 measured by the GPC was 4.5 × 10⁴, dispersion ratio: 2.0

### Example 1

A primer layer composition described below was applied to a smooth surface of an aluminum plate which had been defatted by the usual procedure so as to form a dry film having a thickness of 30 mg/dm², and the plate was dried at 150°C for 10 minutes. Thus a primer layer was provided.

### Primer Layer Composition

| | |
|---|---|
| Epikote 1001 | |
| (supplied by Shell Chemicals, Ltd.) | 100 parts |
| Phenol novolak resin (M.W. 2000) | 50 parts |
| Methyl cellosolve | 1000 parts |

On the primer layer provided on the aluminum support, the following photosensitive composition was applied to the dry thickness of 5 mg/dm² and dried. Thus a photosensitive layer was provided.

### Photosensitive Composition

| | |
|---|---|
| Polymer No. 1 (a polymer containing alcoholic hydroxyl groups) | 100 parts |
| Diazo Resin No. 1 (p-diazodiphenylamine-formaldehyde resin) | 10 parts |
| Victorian blue BOH | 2 parts |
| Methyl cellosolve | 2000 parts |

Then, on the above-described photosensitive layer, the following silicone rubber composition was applied to the thickness of 15 mg/dm² in the dry condition and dried. Thus a silicone rubber layer was formed.

### Silicone Rubber Composition

| | |
|---|---|
| YF-3057 | |
| (supplied by Toshiba Silicone K.K.) | 100 parts |
| TSL-8180 | |
| (supplied by Toshiba Silicone K.K.) | 10 parts |
| Aerosil R-972 | |
| (supplied by Nippon Aerosil K.K.) | 3 parts |
| Dibutyltin dilaurate | 0.8 part |
| Hexane | 1400 parts |

Over the thus formed silicone rubber layer, a polypropylene film having a thickness of 5 µ, one side of which had been matted, was laminated and thus a waterless lithographic printing plate was obtained. A positive film was laid on this printing plate and the plate was exposed to light from a 3 KW super high pressure mercury lamp at 100 mJ/cm². Thereafter, the laminated film was peeled off and the plate was immersed in the following developer for 1 minute. The silicone rubber and unexposed photosensitive layer were removed.

### Developer

| | |
|---|---|
| Phenyl cellosolve | 10 parts |
| Diethanolamine | 4 parts |
| Pionine A-44B (Takemoto Yushi K.K.) | 6 parts |
| Water | 80 parts |

The thus obtained printing plate was mounted on a Heydel GTO (manufactured by Heydel AG) from which the water-supply means had been removed and printing was carried out with TPM ink (aqualess type black ink supplied by Toyo Ink Seizo K.K.). The ink was satisfactorily applied on the printing plate and more than 15,000 sheets were printed with no non-image portion staining.

On the non-image portion of the printing plate, scratch was made by a continuous loading scratch strength tester (Type-HEIDON-1B manufactured by Shinto Kagaku K.K.) using a 0.4 mm sapphire stylus with a load of 20 g. Using this printing plate, printing was carried out, but no stain in line with the scratch appeared.

### Comparative Example 1

Waterless photosensitive lithographic printing plates A - F were obtained in the same manner as in Example 1 using polymers indicated in Table 1 instead of polymer No. 1.

The obtained photosensitive lithographic printing plates A - F were developed with the following developer. Only C and D gave good images.

### Developer

| | |
|---|---|
| Phenyl cellosolve | 10 parts |
| Diethanol amine | 4 parts |
| Pionine A-44B | 6 parts |
| Water | 80 parts |

The printing plates C and D were used for printing in the same manner as in Example 1. However, in the case of printing plate D, staining occurred in the printed sheets after about 5,000 sheets were printed. In the case of printing plate C, dot loss occurred in the printed sheets after about 15,000 sheets were printed.

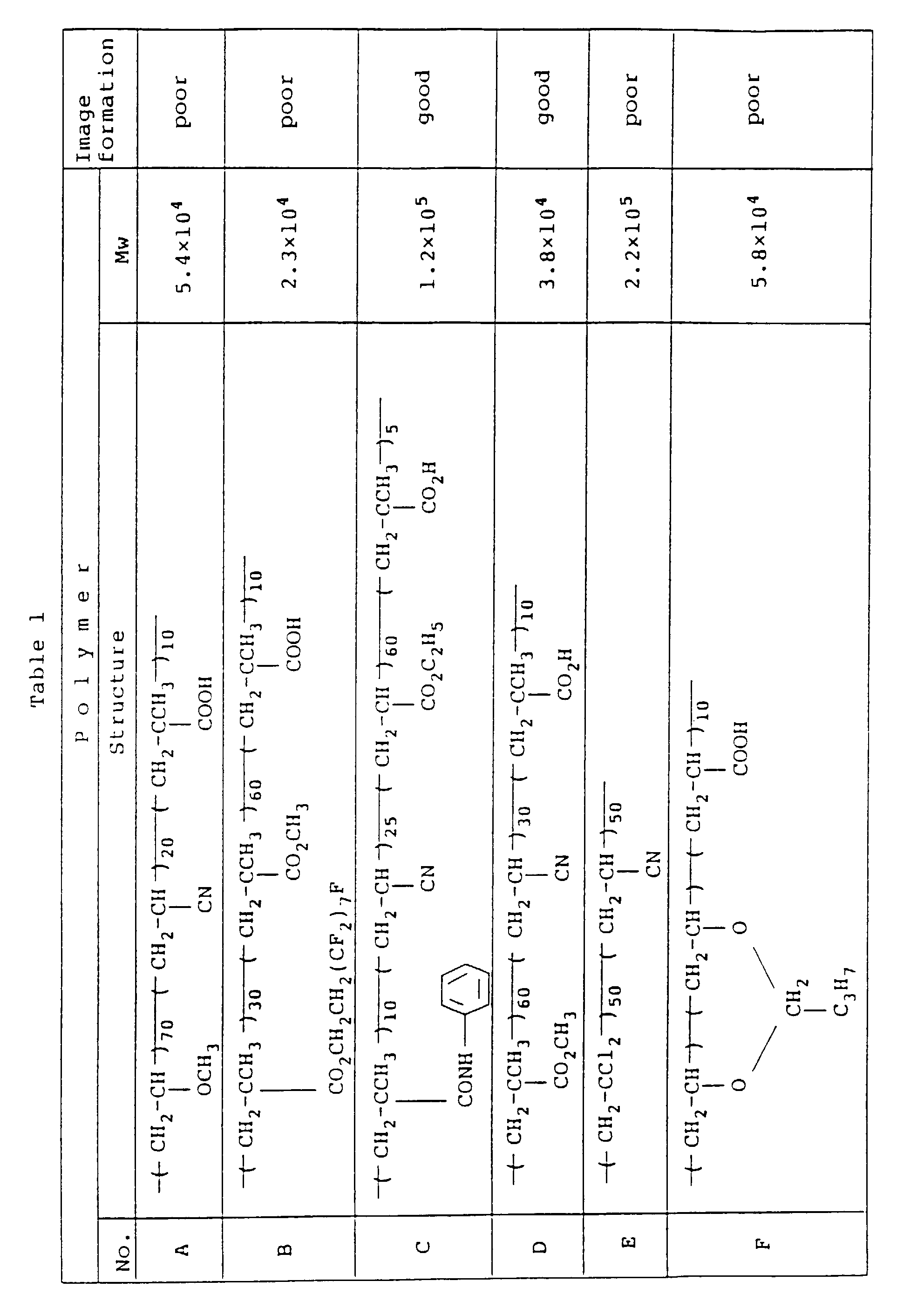

### Example 2

An aluminum plate, which had been defatted and rinsed, was anodized in a 40 wt.% sulfuric acid by 1.5 A/dm² electric current at 30°C for 2 minutes. Thereafter, it was rinsed with water and treated in a 1 wt.% sodium silicate aqueous solution at 85°C for 25 seconds. The plate was finally rinsed with water and Support No. 2 was obtained.

The following photosensitive composition was applied on the surface of Support No. 2 to a thickness of 5 mg/dm² in the dry state and dried.

### Photosensitive Composition

| | |
|---|---|
| Polymer 2 (polymer containing alcoholic hydroxyl group) | 100 parts |
| Diazo resin (p-diazodiphenylamine-formaldehyde resin | 50 parts |
| Oil blue | |
| Methyl cellosolve | |

On the thus formed photosensitive layer, the following silicone composition was applied to a thickness of 20 mg/dm² in the dry state.

### Silicone Rubber Composition

| | |
|---|---|
| Silicone SH-237 (supplied by Toshiba Silicone K.K.) | 100 parts |
| Methyl-tris-(methylethylketonoxim)silane | 4 parts |
| Dibutyltin acetate | 0.4 parts |

The thus form printing plate was exposed to light from a 3 KW super high pressure mercury lamp at 100 mJ/cm² through a positive film laid thereon. Thereafter, the plate was immersed in the following developer and the photosensitive layer and the silicone rubber of the unexposed portion were removed by rubbing with a pad. Developer

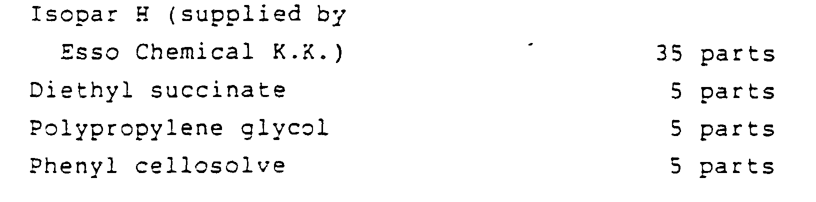

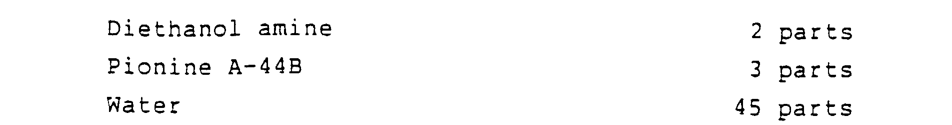

The thus obtained printing plate was used for printing in the same manner as in Example 1. Application of ink was satisfactory and good prints free from staining were obtained.

As has been described, the present invention overcomes the defects of the prior art and provides a photosensitive lithographic printing plate which does not require wetting water and is excellent in adhesion of the photosensitive layer and the silicone rubber layer or the photosensitive layer and the support or the primer layer.

### Description for the following Contracting State: FR

This invention relates to a photosensitive lithographic printing plate, more particularly, a photosensitive lithographic printing plate which comprises a support and a photosensitive layer and a silicone rubber layer applied on the surface of the support in this order and does not require wetting water in printing.

In the lithography, printing is effected based on delicate balance of ink and water created by lipophilicity of the image portion and hydrophilicity of the non-image portion, wherein considerable skill is required.

In the printing system in which wetting water is required, printing plates are prepared by exposing a plate which comprises a hydrophilic support and a lipophilic photosensitive layer provided on the former to light through an image film and developing the plate so as to form the lipophilic image portion and the hydrophilic non-image portion. In printing, the non-image portion is wetted and printing ink is applied on the image portion. The ink adheres to the image portion only and not to the wetted non-image portion. In this printing system, however, the control of delicate balancing of the wetting water and the printing ink is difficult and often emulsification of ink or immigration of ink to the non-image portion occurs causing insufficiency in ink density or staining of the non-image portion, and wastes paper.

There is also a problem that the wetting water is transferred to printing paper, which causes dimensional change of paper inviting difficulty especially in multicolor printing.

Therefore, development of lithographic printing plate which does not require the wetting water (hereinafter, we call it "waterless lithographic plate" in places) has been attempted. Japanese Patent Publication Nos. 44-23042 and 46-16044 disclose waterless lithographic plates which comprise a support, a photosensitive layer and a silicone rubber layer provided on the photosensitive layer, and processes for preparing a printing plate wherein the silicone rubber layer is removed when the plate is developed and the photosensitive layer is dissolved by a developer. Japanese Patent Publication Nos. 56-26923 and 54-23150 disclose similar lithographic plates which comprise a support, a photosensitive layer and a silicone rubber layer and processes for preparing a lithographic printing plate, wherein the photosensitive layer is not dissolved but photochemical adhesion or photochemical separation of the photosensitive layer and the silicone rubber layer is caused and thus the silicone rubber layer is selectively swelled and removed.

Further, Japanese Patent Publication No. 61-54219, Japanese Laid-Open Patent Publication Nos. 60-229031 and 62-194255 disclose waterless lithographic printing plates which comprise a support, a primer layer, a photosensitive layer and a silicone rubber layer.

In the processes disclosed in said Japanese Patent Publications Nos. 44-23042 and 46-16044, there is a problem that the image portion is rather deeply cleared in developing and, therefore, the printing ink must be thickly applied in order to sufficiently cover the image portion, and the adhesion between the photosensitive layer and the silicone rubber layer or the support is not entirely satisfactory. Also in the processes disclosed in said Japanese Patent Publication Nos. 54-26923 and 56-23150, the designing of the silicone rubber layer is difficult because delicate adhesion of the silicone rubber layer and the photosensitive layer is relied upon, and, therefore, the obtained printing plate is not satisfactory in the scratch resistance and reproducibility of the image, although the above-described difficulty in the ink application can be obviated.

Further in the process disclosed in said Japanese Laid-Open Patent Publication No. 60-229031, there is a defect that the adhesion of the photosensitive layer and the silicone rubber layer or the adhesion of the photosensitive layer and the primer layer, if the latter is employed, is not sufficient, although the above-described defects are overcome. In the processes of Japanese Patent Publication No. 61-54219 and Japanese Laid-Open Patent Publication No. 62-194255, the primer layer is heat-crosslinkable and is thermally cured after it has been applied on the surface of a support and, therefore, the process is inferior in productivity and economically disadvantageous.

The object of the present invention is to provide a photosensitive lithographic printing plate which does not require wetting water. Particularly, it is to provide a photosensitive lithographic printing plate excellent in the adhesion of the photosensitive layer and the support or the primer layer, which does not require wetting water.

In order to solve the above problems, we carried out an intensive study and have found that the above-mentioned object can be achieved by a photosensitive lithographic printing plate which comprises a support and at least a photosensitive layer and a silicone rubber layer provided on the support in this order, said photosensitive layer containing (1) a diazo resin and (2) a polymer containing an ester or amide of (meth)acrylic acid having hydroxyl groups or a photosensitive lithographic printing plate which comprises a support and at least a primer layer, a photosensitive layer and a silicone rubber layer provided on the support in this order, said photosensitive layer containing at least (1) a diazo resin and (2) a polymer containing an ester or amide of (meth)acrylic acid having hydroxyl groups. These photosensitive lithographic printing plates do not require wetting water.

Now the invention will be specifically described in detail.

The photosensitive layer used in the present invention contains a diazo resin and a polymer containing an ester or amide of (meth)acrylic acid having hydroxyl groups (hereinafter referred to as "hydroxyl-containing polymer") as an essential component.

As the above-mentioned diazo resin, a diazo resin obtained by condensation of a diazo compound and an active carbonyl compound (such as formaldehyde, acetoaldehyde or benzaldehyde) in an acidic solvent such as sulfuric acid, phosphoric acid, hydrochloric acid, as described in page 33 of Vol. 17 (1973) of "Photographic Science and Engineering", U.S. Patent Nos. 2,063,631; 2,679,498; 3,050,502; Japanese Laid-Open Patent Publication No. 59-78340,; a diazo resin obtained by condensation of a diazo compound and a diphenylether derivative as described in Japanese Patent Publication No. 49-4001, can be used.

The counter anions of the diazo resin used in the present invention include anions which form stable salts with said diazo resin and that makes said resin soluble in organic solvents. These include organic carboxylic acids such as decanoic acid, benzoic acid, organic phosphoric acid such as phenylphosphoric acid, sulfonic acid. Typical examples are, aliphatic and aromatic sulfonic acids such as methanesulfonic acid, chloroethanesulfonic acid, dodecanesulfonic acid, benzenesulfonic acid, toluenesulfonic acid, benzenesulfonic acid, mesitylenesulfonic acid, anthraquinonesulfonic acid, 2-hydroxy-4-methoxybenzophenone-5-sulfonic acid, hydroquinone sulfonic acid, 4-acetylbenzenesulfonic acid, dimethyl-5-sulfo-isophthalates,; hydroxyl-containing aromatic compounds such as 2,2′,4,4′-tetrahydroxybenzophenone; 1,2,3-trihydroxybenzophenone; 2,2′,4-trihydroxybenzophenone,; perhalogenated Lewis acids such as hexafluorophosphoric acid, tetrafluoroboric acid,; perhalogenic acids such as HClO₄, HIO₄,, although they are not limited thereto. The diazo resins having a weight average molecular weight of 200-10000, preferably 500-5000 with styrene as reference, measured by the gel permeation chromatography (GPC) of a coupling product with β-naphthol.

In the present invention, the photosensitive layer, usually contains 1-90 wt.%, preferably 3-60 wt.% of the above-described diazo resin.

In the present invention, polymers of an ester or amide of (meth)acrylic acid containing alcoholic hydroxyl groups are preferred as a hydroxyl-containing polymers. Examples of the usable ester or amide of a (meth)acrylic acid containing alcoholic hydroxyl groups are 2-hydroxyethyl acrylate, 2-hydroxyethyl methacrylate, N-(4-hydroxyethylphenyl) methacrylamide, hydroxymethyldiacetone (meth)acrylamide,.

Examples of the monomers copolymerizable with the above-mentioned hydroxyl-containing monomer are:
(1) aromatic hydroxyl-containing monomers such as N-(4-hydroxyphenyl)acrylamide, N-(4-hydroxyphenyl)methacrylamide, N-(4-hydroxyphenyl)methacrylamide; o-, m- or p-hydroxystyrene; o-, m- or p-hydroxyphenyl acrylate or methacrylate;
(2) α-β unsaturated carboxylic acids such as acrylic acid, methacrylic acid, maleic anhydride,;
(3) (substituted) alkyl acrylates such as methyl acrylate ,ethyl acrylate, propyl acrylate, butyl acrylate, amyl acrylate, hexyl acrylate, octyl acrylate, 2-chloroethyl acrylate 2-hydroxyethyl acrylate, glycidyl acrylate, N-dimethylaminoethyl acrylate,;
(4) (substituted) alkyl methacrylates such as methyl methacrylate, ethyl methacrylate, propyl methacrylate, butyl methacrylate, amyl methacrylate, cyclohexyl methacrylate, 2-hydroxyethyl methacrylate, 4-hydroxybutyl methacrylate, glycidyl methacrylate, N-dimethylaminoethyl methacrylate,;
(5) acrylamides or methacrylamides such as acrylamide methacrylamide, N-methylolacrylamide, N-ethylacrylamide, N-hexylmethacrylamide, N-cyclohexylacrylamide, N-hydrohexyethylacrylamide, N-phenylacrylamide, N-nitrophenylacrylamide, N-ethyl-N-phenylacrylamide;
(6) vinyl ethers such as ethylvinylether, 2-chloroethyl vinylether, hydroxyethylvinylether, propylvinylether, butylvinylether, octylvinylether, phenylvinylether;
(7) vinyl esters such as vinyl acetate, vinyl chloroacetate, vinyl butyrate, vinyl benzoate;
(8) styrenes such as styrene, α-methylstyrene, chlorostyrene;
(9) vinyl ketones such as methylvinyl ketone, ethylvinyl ketone, propylvinyl ketone, phenylvinyl ketone;
(10) olefines such as ethylene, propylene, isobutylene, butadiene, isobutylene;
(11) N-vinylpyrrolidone, N-vinylcarbazol, 4-vinylpyridine, acrylonitrile, methacrylonitrile,.

The hydroxyl group content of the above-described monomer containing a hydroxyl group is not specifically limited, although it is preferably 5-100 wt.% and more preferably 20-100 wt.%.

The weight average molecular weight of the hydroxyl-containing polymer in accordance with the present invention measured by the GPC method (in comparison with styrene reference) should preferably be 5,000-1,000,000. If the molecular weight is less than 5,000, the photosensitive layer after exposure to light may still be attacked by the solvent or the developing solution and, if the molecular weight is more than 1,000,000, the usable solvent is limited.

The content of the above-described hydroxyl-containing polymer in the photosensitive layer is usually 10-99 wt.% and preferably 40-97 wt.%.

The weight content ratio of the diazo resin and the hydroxyl-containing polymer should preferably be 1/99 - 90/10.

If the diazo resin content ratio is less than 1/99, the light-exposed resin is not sufficiently crosslinked and thus may be attacked by the solvent applied or a developing solution. On the other hand, when the diazo resin content ratio is more than 90/10, the polymer content is small, i.e., the hydroxyl content is small and thus the adhesion to the silicone rubber layer becomes unsatisfactory.

The photosensitive layer in accordance with the present invention may contain other photosensitive substances which contain addition-polymerizable vinyl groups and become insoluble upon exposure to light.

The compounds having addition-polymerizable vinyl groups are compounds which have two or more polymerizable terminal ethylenic groups and have a boiling point of not lower than 100°C under the normal pressure, such as unsaturated carboxylic acid, esters of an unsaturated carboxylic acid and an aliphatic polyhydroxyl compound, esters of an unsaturated carboxylic acid and an aromatic polyhydroxylic compound, esters of an unsaturated carboxylic acid and a polybasic carboxylic acid or the above-mentioned aliphatic polyhydroxylic compound or the aromatic polyhydroxyl compounds. Specific examples are described in Japanese Laid-Open Publication No. 59-71048.

The photosensitive layer in accordance with the present invention may contain a dye, a pigment, a visualizer-upon-exposure, an applicability-improver. in addition to the above-described ingredients in order to improve image-visibility after exposure, image-visibility after development and applicability.

Examples of the usable dyes are triphenylmethane, diphenylmethane, oxazine, xanthene, iminonaphthoquinone, azomethine or anthraquinone dyes such as victoria pure blue BOH, oil blue #603, oil pink #312, patent pure blue, crystal violet, leucocrystal violet, brilliant green, ethyl violet, methyl green, erythrosine B, basic fuchsin, malachite green, leucomalachite green, m-cresol purple, cresol red, xylenol blue, rhodamine B, auramine, 4-p-diethylaminophenyliminonaphthoquinone, cyano-p-diethylaminophenylacetoanilide.

The above-mentioned resins are contained in the photosensitive layer usually in an amount of about 0.01 - about 10 wt.%, preferably about 0.05 - about 8 wt.%.

Examples of the applicability-improver are an alkylether such as ethyl cellulose, methyl cellulose, etc., fluorine-containing surfactants, nonionic surfactants such as Pluronic L-64 (marketed by Asahi Denka K.K.), FC-430 (marketed by Sumitomo 3M K.K.).

Examples of the visualizer-upon-exposure are oxadiazole compounds as described in Japanese Laid-Open Patent Publication No. 54-74728, triazine compounds as described in Japanese Laid-Open Patent Publication No. 53-36223.

In the present invention, the thickness of the photosensitive layer is preferably 0.1 mg/dm² - 30 mg/dm² and more preferably 0.5 mg/dm² - 18 mg/dm².

In the present invention, a primer layer can be provided between the above-described photosensitive layer and the support.

Known various primer layers can be employed. The primer layer which is formed by thermally curing an epoxy resin, polyurethane resin. with the aid of a suitable hardener as described in Japanese Laid-Open Patent Publication No. 61-54219; the primer layer which is formed by photochemically curing a dimeric photo-curable resin as described in Japanese Laid-Open Patent Publication No. 60-229031 can be employed. The diazo resins used for the photosensitive layer can be used for the primer layer usually in an amount of 1-90 wt.%, preferably 3-60 wt.%. The same hydroxyl-containing polymer as used for the photosensitive layer, polyvinyl alcohol derivatives, epoxy resins, novolak resins, gelatin, cellulose can be used for the primer layer. These hydroxyl-containing polymers are contained in an amount of 10-99 wt.%, preferably 40-97 wt.%.

In the present invention, the primer layer may contain fillers such as titanium dioxide, halation-preventers, coloring agents such as dyes and pigments, applicability-improvers, plasticizers, stabilizers, oleophilizers in an amount of not more than 10 wt.% in addition to the above-described essential components.

The same dyes and applicability-improvers as used for the photosensitive layer can be used for the primer layer.

Examples of the plasticizers, which provide flexibility, abrasion resistance, are butyl phthalate, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, oligomers of acrylic or methacrylic acid.

In order to improve affinity of the image portion to printing ink, various additives having hydrophobic groups including modified novolak resins such as p-octylphenol-formalin novolak resin, p-t-butylphenol-formalin novolak resin, p-t-butylphenol-benzaldehyde resin, and o-naphthoquinonediazide sulfonic acid esters (the esterification rate of the OH groups is 20-70 mol%) of these modified novolak resins can be added.

The primer layer is formed by dissolving the above-described photo-curable diazo resin or a composition containing the same and a hydroxyl-containing polymer in a suitable solvent together with other additives as desired, applying the solution on the support, drying, exposing to light so as to completely decompose the diazo resin and hardening.

The thickness of the primer layer is preferably 1 mg/dm² - 200 mg/dm² and more preferably 3 mg/dm² - 100 mg/dm².

In the present invention, a silicone rubber layer is provided on the above-described photosensitive layer. Linear or somewhat crosslinked organopolysiloxanes are preferably used as a silicone rubber. Said organopolysiloxanes have a molecular weight of several thousand to several hundred thousand and are liquid and wax-like or jelly-like with a suitable consistency if they are crosslinked to some extent. Crosslinking of said organosiloxanes is either of condensation type or of addition type.

Condensation type crosslinking is effected by a condensation reaction, wherein water, alcohol, organic acid, etc. are liberated. A mixture of a linear organopolysiloxane, which has hydroxyl groups at both ends or in a part of the main chain, and a silicone crosslinking agent and the reaction product of the two are especially useful. In either case, a condensation catalyst is preferably added.

The main chain of said organopolysiloxanes comprises the repeating unit 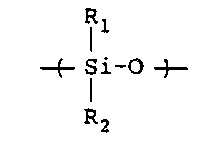 wherein R₁ and R₂ are respectively an alkyl, aryl or alkenyl group which may have substituents such as cyano, halogen, hydroxyl or combination thereof. Methyl, phenyl, vinyl and trifluoropropyl are preferred and methyl is most preferred.

Said silicone crosslinking agents are deacetation type, deoximation type, dealcoholization type, deamination type, or dehydration type condensation silicone crosslinking agents, which contain functional groups represented by 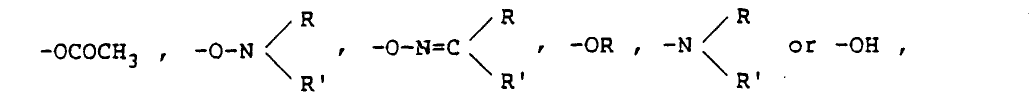 wherein R and R′ stand for alkyls. Specific examples thereof are tetraacetoxysilane, methyltriacetoxysilane, ethyltriacetoxysilane, phenyltriacetoxysilane, dimethylacetoxysilane, diethylacetoxysilane, vinyltriacetoxysilane, methyltrimethoxysilane, dimethyldimethoxysilane, vinyltrimethoxysilane, methyl-tris-(acetonoxime)silane, methyl-tri(N-methyl-N-acetylamino)silane, vinyl-tri(methylethylketoxime)silane, methyl-tri(methylethylketoxime)silane, oligomers thereof.

The crosslinking agent is preferably used in an amount of 0.5-30 parts by weight per 100 parts by weight of organopolysiloxane.

Examples of the above-mentioned condensation catalysts are organic tin carboxylate, titanate esters, naphthenic acid.

The term "addition type condensation catalyst" means those of which hydrogen adds to unsaturated groups such as the vinyl(-CH=CH₂) group in the organopolysiloxane.

Specific examples are a mixture of a vinyl-containing organopolysiloxane, hydrogenated organopolysiloxane, and a platinum catalyst (chloroplatinic acid, for instance).

Said organopolysiloxanes have the same repeating units as described above with respect to that of the condensation type in the main chain.

Either of condensation type silicone rubber and addition type silicone rubber or both can be used as the silicone rubber layer in the present invention.

Organopolysiloxanes which have both hydroxyl groups and unsaturated groups and are of both condensation type and addition type can also be used.

Of the commercially available silicone rubbers usable in the present invention, preferred are condensation type silicone rubbers such as KS-705F; KE-41, 42 and 44 supplied by Shin'etsu Kagaku K.K. YE5505, YF3057, supplied by Toshiba Silicone K.K.; SH-781, PRX-305, SH-237 supplied by Toray Silicone K.K.; and addition type silicone rubbers KS-837, KE-103, KE-106, KE-1300 supplied by Toshiba Silicone; TSE-3032, RTU-B supplied by Toshiba Silicone K.K.; SH-9555 supplied by Toray Silicone K.K..

Inorganic fillers such as silica, titanium oxide, aluminum oxide can be used in order to improve the strength of silicone rubber. Silica is preferred. Fillers having average particle diameter of not larger than 500 nm are preferred from the viewpoint of dispersibility and dispersion stability.

The thickness of the silicone rubber layer in the present invention should preferably be as small as possible from the viewpoints of image quality and developability. From the viewpoint of printing durability and resistance to staining, however, some extent of thickness is required. Therefore, 3 mg/dm² - 50 mg/dm² is preferable and 5 mg/dm² - 30 mg/dm² is more preferable.

An adhesive layer of an epoxy resin, for instance, can be provided between the photosensitive layer and the silicone rubber layer. Various kinds of reactive crosslinking agent, silane couplers can be used for the adhesive layer. The thickness of the adhesive layer should preferably be 0.1 mg/dm² - 5 mg/dm².

In the waterless lithographic printing plate of the present invention, a protective layer may be provided on the surface of the silicone rubber layer. Such a protective layer can be provided by laminating a polypropylene film as disclosed in Japanese Laid-Open Patent Publication No. 61-614 or applying a high polymer as disclosed in Japanese Laid-Open Patent Publication No. 61-27545.

Any support plates which can be set on ordinary lithographic printing apparatuses and have satisfactory flexural rigidity to bear the load in printing can be used in the present invention, and are not specifically limited in material and structure. Paper such as coated paper, metal plates such as aluminum plate, sheets of plastics such as polyethylene terephthalate are used.

However, aluminum plate or composite material including aluminum foil is preferable and aluminum plate is most preferred from the viewpoint of printing durability.

In the present invention, the surface of aluminum plates and aluminum foils are preferably roughened, anodized and further treated with a silicate salt. The silicate treatment is carried out by soaking aluminum plates in a 0.1-10% sodium silicate aqueous solution for 1 sec. - 2 min. at 30-95°C, preferably for 10 sec. - 2 min. at 40-95°C.

The thus prepared photosensitive lithographic printing plate is imagewise exposed and developed with a developer so as to remove the photosensitive layer together with the silicone rubber layer. Thus the support and the primer layer appear as the image portion and thus a waterless lithographic printing plate is obtained.

The image portion will preferably be dyed during or after developing with a cathionic dye such as crystal violet, victorian blue BOH.

Any light sources which emit ultraviolet rays and visible rays having a wavelength of not less than 180 nm can be used for exposure although a carbon arc light, a mercury lamp, a xenon lamp, a metal halide lamp and strobo light are suitable.

The developer for developing the photosensitive layer is an aqueous solution containing a polar solvent, an alkaline compound such as an amine, a surfactant, and further an aliphatic hydrocarbon (hexane, heptane, "Isopar E.E.G." supplied by Esso Chemical Company, gasoline, kerosene), an aromatic hydrocarbon (toluene, xylene, etc.) or a halogenated hydrocarbon (triclene) as desired.

### Polar Solvents

Alcohols such as methanol, ethanol, water, etc.

Ethers such as methyl cellosolve, ethyl cellosolve, butyl cellosolve, methyl carbitol, ethyl carbitol, butyl carbitol, dioxane.

Ketones such as acetone, methylethylketone, etc.

Esters such as ethyl acetate, methyl cellosolve acetate, cellosolve acetate, carbitol acetate.

Developing can be effected by any known procedure such as rubbing the plate with a developing pad containing a developer as described above, pouring the developer on the surface of the printing plate and, thereafter, rubbing with a developing brush.

### Specific Description of the Invention

Now the invention will be illustrated in detail by way of working examples.

### [Synthesis of Diazo Resin No. 1]

Under the ice-cooled condition, 14.5 g of p-diazophenylamine sulfate was dissolved in 40.9 g of concentrated sulfuric acid. To this solution, 1.0 g of paraformaldehyde was slowly added so that the temperature would not exceed 10°C. The reaction mixture was further stirred under the ice-cooled condition for 2 hours. Thereafter, the reaction mixture was dropped into 500 ml of ethanol. The formed precipitate was collected by filtration, and washed with ethanol. The thus obtained precipitate was dissolved in 100 ml of pure water, and a cold thick solution containing 6.8 g of zinc chloride was added. The formed precipitate was collected by filtration, washed with ethanol and dissolved in 150 ml of pure water. To this solution, a cold concentrated solution containing 8 g of hexafluorophosphoric acid ammonium was added. The formed precipitate was collected by filtration, washed and dried at 30°C for 24 hours. Thus Diazo Resin No. 1 was obtained.

The weight average molecular weight Mw of the Diazo Resin No. 1 measured with respect to a coupling product with β-naphthol by the GPC process was 1500 with styrene as reference. The number average molecular weight was 500.

### [Synthesis of Polymer No. 1]

To 700 g of the rectified dioxane, 150 g of 2-hydroxyethyl methacrylate, 60 g of acrylonitrile, 79.5 g of methyl methacrylate and 10.5 g of methacrylic acid (37:35:24:4 in the molar ratio) were added (the total monomer concentration was 4.6 moles/ℓ), and to the resulting solution, 15 g (2 mol.%) of benzoyl peroxide was slowly added to allow polymerization under refluxing in a nitrogen atmosphere for 8 hours. After the reaction was finished, 0.5 g of hydroquinone was added to the reaction mixture and the solvent was distilled away under reduced pressure. When the mixture became viscous, the polymer mixture was poured onto a stainless steel plate and dried in vacuo. Thus 270 g of resin (Polymer No. 1) in the form of a plate was obtained. The measured GPC value of the polymer was as follows.
Mw: 4.80 × 10⁴, dispersion ratio: 2.2

### [Synthesis of Polymer No. 2]

Polymer No. 2 was obtained by repeating the procedures of Synthesis of Polymer No. 1 using hydroxymethyldiacetonemethacrylamide.

The Mw value of Polymer No. 2 measured by the GPC was 4.5 × 10⁴, dispersion ratio: 2.0

### Example 1

A primer layer composition described below was applied to a smooth surface of an aluminum plate which had been defatted by the usual procedure so as to form a dry film having a thickness of 30 mg/dm², and the plate was dried at 150°C for 10 minutes. Thus a primer layer was provided.

### Primer Layer Composition

| | |
|---|---|
| Epikote 1001 | |
| (supplied by Shell Chemicals, Ltd.) | 100 parts |
| Phenol novolak resin (M.W. 2000) | 50 parts |
| Methyl cellosolve | 1000 parts |

On the primer layer provided on the aluminum support, the following photosensitive composition was applied to the dry thickness of 5 mg/dm² and dried. Thus a photosensitive layer was provided.

### Photosensitive Composition

| | |
|---|---|
| Polymer No. 1 (a polymer containing alcoholic hydroxyl groups) | 100 parts |
| Diazo Resin No. 1 (p-diazodiphenylamine-formaldehyde resin) | 10 parts |
| Victorian blue BOH | 2 parts |
| Methyl cellosolve | 2000 parts |

Then, on the above-described photosensitive layer, the following silicone rubber composition was applied to the thickness of 15 mg/dm² in the dry condition and dried. Thus a silicone rubber layer was formed.

### Silicone Rubber Composition

| | |
|---|---|
| YF-3057 | |
| (supplied by Toshiba Silicone K.K.) | 100 parts |
| TSL-8180 | |
| (supplied by Toshiba Silicone K.K.) | 10 parts |
| Aerosil R-972 | |
| (supplied by Nippon Aerosil K.K.) | 3 parts |
| Dibutyltin dilaurate | 0.8 part |
| Hexane | 1400 parts |

Over the thus formed silicone rubber layer, a polypropylene film having a thickness of 5 µ, one side of which had been matted, was laminated and thus a waterless lithographic printing plate was obtained. A positive film was laid on this printing plate and the plate was exposed to light from a 3 KW super high pressure mercury lamp at 100 mJ/cm². Thereafter, the laminated film was peeled off and the plate was immersed in the following developer for 1 minute. The silicone rubber and unexposed photosensitive layer were removed.

### Developer

| | |
|---|---|
| Phenyl cellosolve | 10 parts |
| Diethanolamine | 4 parts |
| Pionine A-44B (Takemoto Yushi K.K.) | 6 parts |
| Water | 80 parts |

The thus obtained printing plate was mounted on a Heydel GTO (manufactured by Heydel AG) from which the water-supply means had been removed and printing was carried out with TPM ink (aqualess type black ink supplied by Toyo Ink Seizo K.K.). The ink was satisfactorily applied on the printing plate-and more than 15,000 sheets were printed with no non-image portion staining.

On the non-image portion of the printing plate, scratch was made by a continuous loading scratch strength tester (Type-HEIDON-18 manufactured by Shinto Kagaku K.K.) using a 0.4 mm sapphire stylus with a load of 20 g. Using this printing plate, printing was carried out, but no stain in line with the scratch appeared.

### Comparative Example 1

Waterless photosensitive lithographic printing plates A - F were obtained in the same manner as in Example 1 using polymers indicated in Table 1 instead of polymer No. 1.

The obtained photosensitive lithographic printing plates A - F were developed with the following developer. Only C and D gave good images.

### Developer

| | |
|---|---|
| Phenyl cellosolve | 10 parts |
| Diethanol amine | 4 parts |
| Pionine A-44B | 6 parts |
| Water | 80 parts |

The printing plates C and D were used for printing in the same manner as in Example 1. However, in the case of printing plate D, staining occurred in the printed sheets after about 5,000 sheets were printed. In the case of printing plate C, dot loss occurred in the printed sheets after about 15,000 sheets were printed.

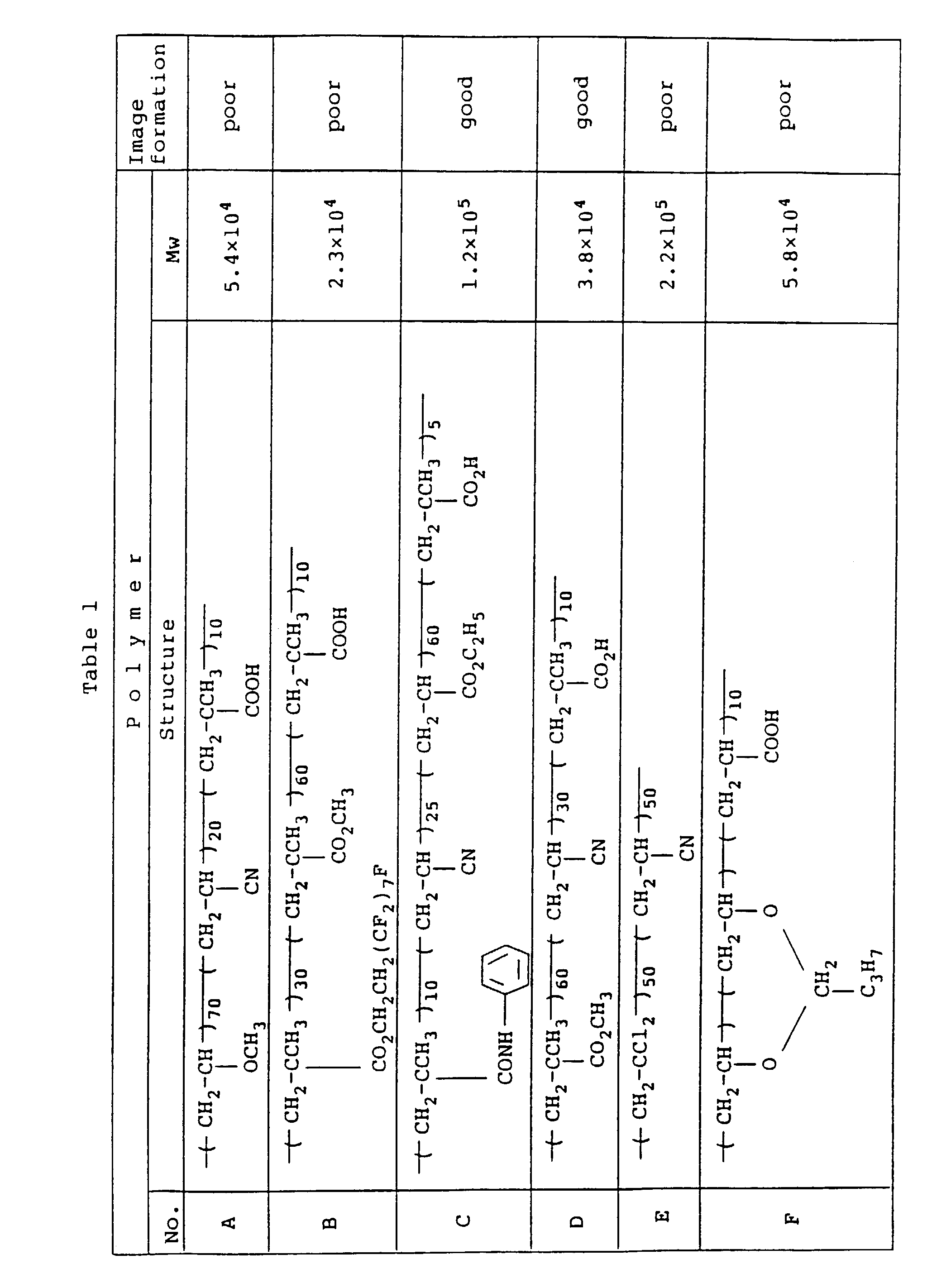

### Example 2

An aluminum plate, which had been defatted and rinsed, was anodized in a 40 wt.% sulfuric acid by 1.5 A/dm² electric current at 30°C for 2 minutes. Thereafter, it was rinsed with water and treated in a 1 wt.% sodium silicate aqueous solution at 85°C for 25 seconds. The plate was finally rinsed with water and Support No. 2 was obtained.

The following photosensitive composition was applied on the surface of Support No. 2 to a thickness of 5 mg/dm² in the dry state and dried.

### Photosensitive Composition

| | |
|---|---|
| Polymer 2 (polymer containing alcoholic hydroxyl group) | 100 parts |
| Diazo resin (p-diazodiphenylamine-formaldehyde resin) | 50 parts |
| Oil blue | |
| Methyl cellosolve | |

On the thus formed photosensitive layer, the following silicone composition was applied to a thickness of 20 mg/dm² in the dry state.

### Silicone Rubber Composition

| | |
|---|---|
| Silicone SH-237 (supplied by Toshiba Silicone K.K.) | 100 parts |
| Methyl-tris-(methylethylketonoxim)silane | 4 parts |
| Dibutyltin acetate | 0.4 parts |

The thus form printing plate was exposed to light from a 3 KW super high pressure mercury lamp at 100 mJ/cm² through a positive film laid thereon. Thereafter, the plate was immersed in the following developer and the photosensitive layer and the silicone rubber of the unexposed portion were removed by rubbing with a pad.

### Developer

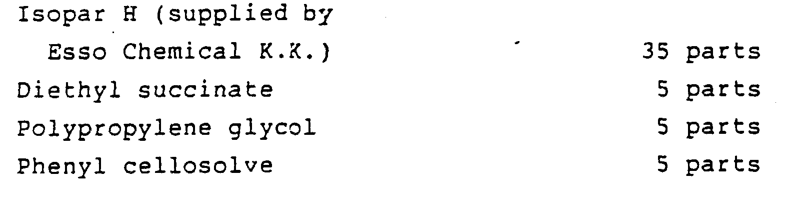

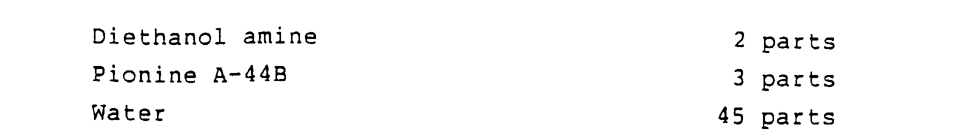

The thus obtained printing plate was used for printing in the same manner as in Example 1. Application of ink was satisfactory and good prints free from staining were obtained.

As has been described, the present invention overcomes the defects of the prior art and provides a photosensitive lithographic printing plate which does not require wetting water and is excellent in adhesion of the photosensitive layer and the silicone rubber layer or the photosensitive layer and the support or the primer layer.

## Claims (Claims for the following Contracting State(s): DE, GB)

1. A photosensitive lithographic printing plate requiring no wetting water, which comprises a support, at least a photosensitive layer and a silicone rubber layer provided on the support in this order, provided that the silicone rubber layer does not contain a copolymer having a silicone macromer and a fluorine-containing monomer in its molecular structure, and wherein the photosensitive layer contains at least (1) a diazo resin and (2) a polymer of an ester or amide of (meth)acrylic acid having hydroxyl groups.

2. A photosensitive lithographic printing plate according to claim 1 which further comprises at least a primer layer, provided on the support.

3. The photosensitive lithographic printing plate according to claim 1 or 2, wherein the hydroxyl group is an alcoholic hydroxyl group.

4. The photosensitive lithographic printing plate according to claims 1 to 3, wherein the hydroxyl-containing polymer is contained in the photosensitive layer in an amount of 10-99 wt.%.

5. The photosensitive lithographic printing plate according to claim 3, wherein the hydroxyl-containing polymer is contained in an amount of 40-97 wt.%.

6. The photosensitive lithographic printing plate according to claims 1-5, wherein the content of the diazo resin in the photosensitive layer is 1-90 wt.%.

7. The photosensitive lithographic printing plate according to claims 1-5, wherein the content of the diazo resin in the photosensitive layer is 3-60 wt.%.

8. The photosensitive lithographic printing plate according to claims 1-7, wherein the hydroxyl-containing monomer is contained in the hydroxyl-containing polymer in an amount of 5-100 wt.%.

9. The photosensitive lithographic printing plate according to claims 1-7, wherein the content of the hydroxyl-containing monomer is 20-100 wt.%.

10. The photosensitive lithographic printing plate according to claims 1-9, wherein the weight average molecular weight of the hydroxyl-containing polymer is 5.000-1.000,000 when it is measured by the GPC method with styrene as reference.

11. The photosensitive lithographic printing plate according to claims 1-10, wherein the ratio of the diazo resin to the hydroxyl-containing polymer is in the range of 1/99 - 90/10.

## Claims (Claims for the following Contracting State(s): FR)

1. A photosensitive lithographic printing plate requiring no wetting water, which comprises a support, at least a photosensitive layer and a silicone rubber layer provided on the support in this order, and wherein the photosensitive layer contains at least (1) a diazo resin and (2) a polymer containing (meth)acrylic acid ester or amide having hydroxyl groups.

2. A photosensitive lithographic printing plate according to Claim 1 which further comprises at least a primer layer.

3. A photosensitive lithographic printing plate according to Claim 1 or 2, wherein the hydroxyl group is an alcoholic hydroxyl group.

4. A photosensitive lithographic printing plate according to Claims 1 to 3, wherein the hydroxyl-containing polymer is contained in the photosensitive layer in an amount of 10-99 wt.%.

5. A photosensitive lithographic printing plate according to Claim 3, wherein the hydroxyl-containing polymer is contained in an amount of 40-97 wt.%.

6. A photosensitive lithographic printing plate according to Claims 1-5, wherein the content of the diazo resin in the photosensitive layer is 1-90 wt.%.

7. A photosensitive lithographic printing plate according to Claims 1-5, wherein the content of the diazo resin in the photosensitive layer is 3-60 wt.%.

8. A photosensitive lithographic printing plate according to Claims 1-7, wherein the hydroxyl-containing monomer is contained in the hydroxyl-containing polymer in an amount of 5-100 wt.%.

9. A photosensitive lithographic printing plate according to Claims 1-7, wherein the content of the hydroxyl-containing monomer is 20-100 wt.%.

10. A photosensitive lithographic printing plate according to Claims 1-9, wherein the weight average molecular weight of the hydroxyl-containing polymer is 5,000-1,000,000 when it is measured by the GPC method with styrene as reference.

11. A photosensitive lithographic printing plate according to Claims 1-11, wherein the ratio of the diazo resin to the hydroxyl-containing polymer is in the range of 1/99 - 90/10.

## Patentansprüche (Patentansprüche für folgende(n) Vertragsstaat(en): DE, GB)

1. Lichtempfindliche lithographische Druckplatte, die kein Befeuchtungswasser benötigt, umfassend einen Träger, mindestens eine lichtempfindliche Schicht und eine Siliconkautschukschicht, die in dieser Reihenfolge auf dem Träger vorgesehen sind, mit der Maßgabe, daß die Siliconkautschukschicht kein Copolymer mit einem Siliconmakromer und einem fluorhaltigen Monomer in dessen Molekülstruktur enthält, und wobei die lichtempfindliche Schicht mindestens (1) ein Diazoharz und (2) ein Polymer aus einem Ester oder Amid von (Meth)Acrylsäure mit Hydroxylgruppen enthält.

2. Lichtempfindliche lithographische Druckplatte nach Anspruch 1, welche weiterhin mindestens eine auf dem Träger vorgesehene Primerschicht umfaßt.

3. Lichtempfindliche lithographische Druckplatte nach Anspruch 1 oder 2, wobei die Hydroxylgruppe eine alkoholische Hydroxylgruppe ist.

4. Lichtempfindliche lithographische Druckplatte nach den Ansprüchen 1 bis 3, wobei das hydroxylhaltige Polymer in der lichtempfindlichen Schicht in einer Menge von 10-99 Gew.-% enthalten ist.

5. Lichtempfindliche lithographische Druckplatte nach Anspruch 3, wobei das hydroxylhaltige Polymer in einer Menge von 40-97 Gew.-% enthalten ist.

6. Lichtempfindliche lithographische Druckplatte nach den Ansprüchen 1 bis 5, wobei der Gehalt des Diazoharzes in der lichtempfindlichen Schicht 1-90 Gew.-% beträgt.

7. Lichtempfindliche lithographische Druckplatte nach den Ansprüchen 1 bis 5, wobei der Gehalt des Diazoharzes in der lichtempfindlichen Schicht 3-60 Gew.-% beträgt.

8. Lichtempfindliche lithographische Druckplatte nach den Ansprüchen 1 bis 7, wobei das hydroxylhaltige Monomer in dem hydroxylhaltigen Polymer in einer Menge von 5-100 Gew.-% enthalten ist.

9. Lichtempfindliche lithographische Druckplatte nach den Ansprüchen 1 bis 7, wobei der Gehalt des hydroxylhaltigen Monomeren 20-100 Gew.-% beträgt.

10. Lichtempfindliche lithographische Druckplatte nach den Ansprüchen 1 bis 9, wobei das gewichtsmittlere Molekulargewicht des hydroxylhaltigen Polymeren 5.000-1.000.000 beträgt, gemessen nach der GPC-Methode mit Styrol als Referenz.

11. Lichtempfindliche lithographische Druckplatte nach den Ansprüchen 1 bis 10, wobei das Verhältnis des Diazoharzes zu dem hydroxylhaltigen Polymer im Bereich von 1/99-90/10 liegt.

## Patentansprüche (Patentansprüche für folgende(n) Vertragsstaat(en): FR)

1. Lichtempfindliche lithographische Druckplatte, die kein Befeuchtungswasser benötigt, umfassend einen Träger, mindestens eine lichtempfindliche Schicht und eine Siliconkautschukschicht, die in dieser Reihenfolge auf dem Träger vorgesehen sind, wobei die lichtempfindliche Schicht mindestens (1) ein Diazoharz und (2) ein Polymer enthält, das einen Ester oder ein Amid von (Meth)Acrylsäure mit Hydroxylgruppen enthält.

2. Lichtempfindliche lithographische Druckplatte nach Anspruch 1, umfassend weiterhin eine auf dem Träger vorgesehene Primerschicht.

3. Lichtempfindliche lithographische Druckplatte nach Anspruch 1 oder 2, wobei die Hydroxylgruppe eine alkoholische Hydroxylgruppe ist.

4. Lichtempfindliche lithographische Druckplatte nach den Ansprüchen 1 bis 3, wobei das hydroxylhaltige Polymer in der lichtempfindlichen Schicht in einer Menge von 10-99 Gew.-% enthalten ist.

5. Lichtempfindliche lithographische Druckplatte nach Anspruch 3, wobei das hydroxylhaltige Polymer in einer Menge von 40-97 Gew.-% enthalten ist.

6. Lichtempfindliche lithographische Druckplatte nach den Ansprüchen 1 bis 5, wobei der Gehalt des Diazoharzes in der lichtempfindlichen Schicht 1-90 Gew.-% beträgt.

7. Lichtempfindliche lithographische Druckplatte nach den Ansprüchen 1 bis 5, wobei der Gehalt des Diazoharzes in der lichtempfindlichen Schicht 3-60 Gew.-% beträgt.

8. Lichtempfindliche lithographische Druckplatte nach den Ansprüchen 1 bis 7, wobei das hydroxylhaltige Monomer in dem hydroxylhaltigen Polymer in einer Menge von 5-100 Gew.-% enthalten ist.

9. Lichtempfindliche lithographische Druckplatte nach den Ansprüchen 1 bis 7, wobei der Gehalt des hydroxylhaltigen Monomeren 20-100 Gew.-% beträgt.

10. Lichtempfindliche lithographische Druckplatte nach den Ansprüchen 1 bis 9, wobei das gewichtsmittlere Molekulargewicht des hydroxylhaltigen Polymeren 5.000-1.000.000 beträgt, gemessen durch die GPC-Methode mit Styrol als Referenz.

11. Lichtempfindliche lithographische Druckplatte nach den Ansprüchen 1 bis 1 1, wobei das Verhältnis des Diazoharzes zu dem hydroxylhaltigen Polymer im Bereich von 1/99-90/10 liegt.

## Revendications (Revendications pour l'(les) Etat(s) contractant(s) suivant(s): DE, GB)

1. Plaque d'impression lithographique photosensible ne nécessitant pas d'eau de mouillage, qui comprend un support, au moins une couche photosensible et une couche de caoutchouc silicone disposées sur le support dans cet ordre, à la condition que la couche de caoutchouc silicone ne contienne pas de copolymère ayant dans sa structure moléculaire un macromère de silicone et un monomère contenant du fluor, et dans laquelle la couche photosensible contient au moins (1) une résine diazoïque et (2) un polymère d'un ester ou amide d'acide (méth)acrylique portant des groupes hydroxyles.

2. Plaque d'impression lithographique photosensible selon la revendication 1, qui comprend en outre au moins une couche primaire disposée sur le support.

3. Plaque d'impression lithographique photosensible selon la revendication 1 ou 2, dans laquelle le groupe hydroxyle est un groupe hydroxyle alcoolique.

4. Plaque d'impression lithographique photosensible selon les revendications 1 à 3, dans laquelle le polymère contenant des groupes hydroxyles est présent dans la couche photosensible à raison de 10 à 99% en poids.

5. Plaque d'impression lithographique photosensible selon la revendication 3, dans laquelle le polymère contenant des groupes hydroxyles est présent à raison de 40 à 97 % en poids.

6. Plaque d'impression lithographique photosensible selon les revendications 1 à 5, dans laquelle la teneur en résine diazoïque dans la couche photosensible est de 1 à 90 % en poids.

7. Plaque d'impression lithographique photosensible selon les revendications 1 à 5, dans laquelle la teneur en résine diazoïque dans la couche photosensible est de 3 à 60 % en poids.

8. Plaque d'impression lithographique photosensible selon les revendications 1 à 7, dans laquelle le monomère contenant des groupes hydroxyles est présent dans le polymère porteur de groupes hydroxyles à raison de 5 à 100 % en poids.

9. Plaque d'impression lithographique photosensible selon les revendications 1 à 7, dans laquelle la teneur en monomère contenant des groupes hydroxyles est de 20 à 100 % en poids.

10. Plaque d'impression lithographique photosensible selon les revendications 1 à 9, dans laquelle le poids moléculaire moyen en poids du polymère contenant des groupes hydroxyles mesuré par la technique de CPG avec le styrène comme référence est de 5.000 à 1.000.000.

11. Plaque d'impression lithographique photosensible selon les revendications 1 à 10, dans laquelle le rapport de la résine diazoïque au polymère contenant les groupes hydroxyles est dans la plage de 1/99 à 90/10.

## Revendications (Revendications pour l'(les) Etat(s) contractant(s) suivant(s): FR)

1. Plaque d'impression lithographique photosensible ne nécessitant pas d'eau de mouillage, qui comprend un support, au moins une couche photosensible et une couche de caoutchouc silicone disposées sur le support dans cet ordre, et dans laquelle la couche photosensible contient au moins (1) une résine diazoïque et (2) un polymère d'un ester ou amide d'acide (méth)acrylique portant des groupes hydroxyles.

2. Plaque d'impression lithographique photosensible selon la revendication 1, qui comprend en outre au moins une couche primaire disposée sur le support.

3. Plaque d'impression lithographique photosensible selon la revendication 1 ou 2, dans laquelle le groupe hydroxyle est un groupe hydroxyle alcoolique.

4. Plaque d'impression lithographique photosensible selon les revendications 1 à 3, dans laquelle le polymère contenant des groupes hydroxyles est présent dans la couche photosensible à raison de 10 à 99% en poids.

5. Plaque d'impression lithographique photosensible selon la revendication 3, dans laquelle le polymère contenant des groupes hydroxyles est présent à raison de 40 à 97 % en poids.

6. Plaque d'impression lithographique photosensible selon les revendications 1 à 5, dans laquelle la teneur en résine diazoïque dans la couche photosensible est de 1 à 90 % en poids.

7. Plaque d'impression lithographique photosensible selon les revendications 1 à 5, dans laquelle la teneur en résine diazoïque dans la couche photosensible est de 3 à 60 % en poids.

8. Plaque d'impression lithographique photosensible selon les revendications 1 à 7, dans laquelle le monomère contenant des groupes hydroxyles est présent dans le polymère porteur de groupes hydroxyles à raison de 5 à 100 % en poids.

9. Plaque d'impression lithographique photosensible selon les revendications 1 à 7, dans laquelle la teneur en monomère contenant des groupes hydroxyles est de 20 à 100 % en poids.

10. Plaque d'impression lithographique photosensible selon les revendications 1 à 9, dans laquelle le poids moléculaire moyen en poids du polymère contenant des groupes hydroxyles mesuré par la technique de CPG avec le styrène comme référence est de 5.000 à 1.000.000.

11. Plaque d'impression lithographique photosensible selon les revendications 1 à 10, dans laquelle le rapport de la résine diazoïque au polymère contenant les groupes hydroxyles est dans la plage de 1/99 à 90/10.
